# FASCICULE DE BREVET EUROPEEN

(11) **EP 4 097 766 B1**
(45) Date de publication et mention de la délivrance du brevet: **01.11.2023**
(21) Numéro de dépôt: 21732380.7
(22) Date de dépôt: 02.04.2021
(51) Int. Cl.: H01L 31/0296, H01L 31/103, H01L 31/109, H01L 31/18

(54) **DISPOSITIF DE PHOTO-DÉTECTION À GRADIENT LATÉRAL DE CONCENTRATION EN CADMIUM DANS LA ZONE DE CHARGE D'ESPACE**
FOTODETEKTIONSVORRICHTUNG MIT EINEM LATERALEN KONZENTRATIONSGRADIENTEN VON CADMIUM IM RAUMLADUNGSBEREICH
PHOTODETECTION DEVICE WITH A LATERAL CONCENTRATION GRADIENT OF CADMIUM IN THE SPACE CHARGE REGION

(30) Priorité: 09.04.2020 FR 2003595
(43) Date de publication de la demande: 07.12.2022
(73) Titulaire: Commissariat à l'énergie atomique et aux énergies alternatives, 75015 Paris (FR)
(72) Inventeur: LOBRE, Clément, 38054 Grenoble CEDEX 09 (FR); ROCHETTE, Florent, 38054 Grenoble CEDEX 09 (FR)
(74) Mandataire: Brevalex
(86) Numéro de dépôt international: PCT/FR2021/050586
(87) Numéro de publication internationale: WO 2021/205101

(56) Documents cités:
- EP-A1- 0 541 973
- EP-A1- 2 937 902
- WO-A1-2013/079446
- FR-A1- 3 023 976
- FR-A1- 3 042 310

## Description

### DOMAINE TECHNIQUE

L'invention concerne le domaine des photodiodes infrarouges en CdₓHg₁₋ₓTe (0<x<1), utilisées pour détecter un rayonnement infrarouge notamment pour des applications en imagerie infrarouge.

### ÉTAT DE LA TECHNIQUE ANTÉRIEURE

Une photodiode comprend un substrat en matériau semi-conducteur, dans lequel une jonction PN sépare une région dopée N d'une région dopée P. A l'équilibre thermodynamique, une zone de charge d'espace, dépourvue de porteurs libres, s'étend de part et d'autre de la jonction PN et induit un champ électrique intense dans la photodiode.

En fonctionnement, l'une parmi la région dopée N et la région dopée P forme une région d'absorption. Lorsqu'un photon de longueur d'onde adaptée est absorbé dans la région d'absorption, il y créé un porteur dit minoritaire. Ce porteur minoritaire diffuse dans le substrat jusqu'à atteindre la zone de charge d'espace, où il est accéléré par le champ électrique intense vers l'autre région dopée. Il se recombine dans cette autre région dopée en formant un courant électrique de recombinaison de porteurs. Une photodiode n'est sensible que dans une gamme de longueurs d'onde déterminée, qui dépend de la largeur de bande interdite, ou gap, dans la région d'absorption. Une faible valeur du gap dans la région d'absorption assure une sensibilité de la photodiode aux grandes longueurs d'onde.

Le courant d'obscurité est une imperfection des photodiodes causée par l'agitation thermique qui fournit une énergie suffisante pour former une paire électron-trou par génération spontanée. Si cette paire électron-trou est formée dans la zone de charge d'espace, il y a formation d'un courant électrique de recombinaison de porteur qui ne correspond pas à une absorption de photon. Une forte valeur du gap dans la zone de charge d'espace assure un courant d'obscurité réduit.

En outre, il est connu que dans un substrat semiconducteur en CdₓHg₁₋ₓTe (alliage de cadmium, mercure et tellure, avec 0<x<1), le gap dépend de la concentration en cadmium. Plus cette concentration est élevée, plus le gap est élevé.

L'homme du métier a donc eu l'idée de réaliser des photodiodes en CdₓHg₁₋ₓTe, avec une région d'absorption à faible teneur en cadmium, pour que la photodiode soit sensible aux grandes longueurs d'onde, et une portion à forte teneur en cadmium. En fonctionnement, au moins une partie de la zone de charge d'espace s'étend dans la portion à forte teneur en cadmium, ce qui permet d'obtenir un courant d'obscurité réduit. Un exemple d'une telle photodiode est décrit dans la demande de brevet WO 2013/079446. Dans ce document, la région d'absorption est dopée N. Un caisson à forte teneur en cadmium s'étend dans la région dopée P, avec une concentration en cadmium sensiblement constante. Le caisson est obtenu en recouvrant un substrat en CdₓHg₁₋ₓTe par une couche riche en cadmium, et en réalisant un recuit d'inter-diffusion au cours duquel les atomes de cadmium de la couche riche en cadmium vont diffuser dans le substrat, très préférentiellement dans la région dopée P. Dans tout le texte, « riche en cadmium » signifie constitué d'un matériau dans lequel au moins un atome sur trois est un atome de cadmium, de préférence un atome sur deux.

Un inconvénient de cette solution est qu'elle nécessite un compromis sur la composition du caisson, pour éviter que ce dernier forme une barrière de potentiel entravant la diffusion des porteurs minoritaires dans la zone de charge d'espace. Il faut donc s'assurer que la concentration en cadmium dans le caisson ne dépasse pas un seuil critique au-delà duquel la sensibilité de la photodiode est fortement affectée. Cela se traduit par la nécessité d'un contrôle précis des conditions du recuit, pour éviter la diffusion d'une trop grande quantité de cadmium vers la région dopée P.

Un objectif de la présente invention est de proposer un dispositif de photo-détection à base de CdₓHg₁₋ₓTe, qui offre à la fois une sensibilité aux grandes longueurs d'onde et un courant d'obscurité réduit, et qui ne présente pas les inconvénients de l'art antérieur.

Un autre objectif de la présente invention est de proposer un procédé de fabrication d'un tel dispositif.

### EXPOSÉ DE L'INVENTION

Cet objectif est atteint avec un dispositif de photo-détection à au moins un pixel, comportant un substrat semiconducteur en CdₓHg₁₋ₓTe (0<x<1), ledit substrat comportant pour chaque pixel :
- une région dopée N, dédiée à l'absorption de photons incidents ;
- une région dopée P, formant une jonction PN avec la région dopée N et affleurant une face dite supérieure du substrat ;
- un plot de contact électrique, en métal, en contact physique direct avec la région dopée P ; et
- un caisson concentré, localisé uniquement dans la région dopée P et présentant une concentration moyenne en cadmium supérieure à la concentration moyenne en cadmium dans la région dopée N.

Selon l'invention, dans chaque pixel du dispositif de photo-détection :
- le caisson concentré présente un gradient de concentration en cadmium, définissant dans ce dernier au moins une zone de gap intermédiaire et au moins une zone fort gap ;
- la zone de gap intermédiaire présente une concentration moyenne en cadmium strictement inférieure à la concentration moyenne en cadmium dans la zone fort gap ; et
- chaque zone de gap intermédiaire est en contact physique direct avec le plot de contact électrique.

Comme chaque zone de gap intermédiaire est en contact physique direct avec le plot de contact électrique. On comprend donc que le gradient de concentration en cadmium est un gradient latéral, c'est-à-dire une variation de la concentration en cadmium dans des plans parallèles au plan du substrat.

Chaque pixel définit une photodiode. Dans chaque pixel, la région dopée P est peu profonde au regard de son étendue latérale, avec par exemple un rapport supérieur ou égal à trois entre sa profondeur et son diamètre. L'étendue latérale désigne sa largeur maximale, respectivement sa longueur maximale, définies toutes deux dans un plan parallèle au plan du substrat.

Dans chaque pixel, la plage de sensibilité spectrale est définie par la concentration en cadmium dans la région dopée N. Cette concentration est fixée librement, et de manière à détecter des photons aux longueurs d'onde souhaitées, préférentiellement dans l'infrarouge.

Comme dans l'art antérieur mentionné en introduction, chaque pixel comporte un caisson à plus forte concentration en cadmium, localisé uniquement dans la région dopée P, et nommé ici « caisson concentré ». Le gap moyen dans le caisson concentré est donc supérieur au gap moyen dans la région dopée N. En fonctionnement, la zone de charge d'espace s'étend au moins en partie dans le caisson concentré, ce qui permet de réduire le courant d'obscurité.

Selon l'invention, dans chaque pixel, le caisson concentré comporte au moins une zone de gap intermédiaire et au moins une zone fort gap. En fonctionnement, la zone de charge d'espace s'étend donc en partie dans la zone de gap intermédiaire, et en partie dans la zone fort gap.

La zone de gap intermédiaire présente une concentration moyenne en cadmium strictement inférieure à la concentration moyenne en cadmium dans la zone fort gap. Le gap moyen dans la zone de gap intermédiaire est donc inférieur au gap moyen dans la zone fort gap. En outre, la zone de gap intermédiaire est en contact physique direct avec le plot de contact électrique. Pour que la collecte des porteurs reste possible, il suffit donc que le gap moyen dans la zone de gap intermédiaire ne forme pas une barrière de potentiel entravant la diffusion des porteurs minoritaires. Il n'est pas gênant, en revanche, que le gap moyen dans la zone fort gap entrave la diffusion des porteurs minoritaires. Dit autrement, la réduction du courant d'obscurité est assurée, au moins, par la zone fort gap, tandis que la collecte des porteurs est assurée, au moins, par la zone de gap intermédiaire.

On s'affranchit ainsi, dans la zone fort gap, des difficultés liées à la recherche d'un compromis entre un gap élevé pour réduire au maximum le courant d'obscurité et un faible gap pour permettre malgré cela la collecte des porteurs.

En outre, puisque le gap moyen dans la zone fort gap peut dépasser un seuil limite au-delà duquel il forme une barrière de potentiel pour les porteurs minoritaires, la valeur moyenne du gap dans le caisson concentré peut être augmentée en comparaison avec l'art antérieur. Le courant d'obscurité est donc encore réduit.

Enfin, puisque la zone fort gap assure à elle seule une forte réduction du courant d'obscurité, le gap moyen dans la zone de gap intermédiaire peut être suffisamment bas pour assurer une bonne collecte des porteurs de charge quelles que soient les conditions de fonctionnement (température, flux de photons, etc).

Le caisson concentré est obtenu simplement en recouvrant le substrat par une couche structurée riche en cadmium et en réalisant un recuit d'inter-diffusion. Au cours de ce recuit, les atomes de cadmium de la couche structurée riche en cadmium vont diffuser dans le substrat, principalement dans la région dopée P. Le gradient de concentration en cadmium est obtenu grâce une ou plusieurs ouverture(s) traversante(s) percée(s) dans la couche structurée riche en cadmium.

De préférence, le dispositif de photo-détection selon l'invention comporte en outre un revêtement structuré recouvrant la face supérieure du substrat, et :
- le revêtement structuré comporte une couche riche en cadmium, constituée d'un alliage comprenant du cadmium et en contact physique direct avec le substrat semiconducteur;
- le revêtement structuré comporte au moins une ouverture traversante ; et
- dans chaque pixel, chaque zone de gap intermédiaire du caisson concentré est surmontée par une ouverture traversante respective du revêtement structuré.

Le revêtement structuré peut comporter plusieurs couches superposées, parmi lesquelles une couche d'étanchéité, distincte de la couche riche en cadmium et apte à bloquer le passage d'éléments dopants vers l'intérieur du substrat semiconducteur.

Le dispositif de photo-détection selon l'invention comporte avantageusement au moins deux pixels, et chaque pixel comporte un même nombre d'ouverture(s) traversante(s) dans le revêtement structuré, répartie(s) de la même façon sur le pixel et présentant les mêmes dimensions d'un pixel à l'autre.

Dans chaque pixel, chaque zone de gap intermédiaire est de préférence entourée latéralement par une partie au moins de l'au moins une zone fort gap.

Dans au moins un pixel, le caisson concentré peut comprendre une unique zone de gap intermédiaire et une unique zone fort gap, avec l'unique zone de gap intermédiaire entourée latéralement par l'unique zone fort gap.

En complément ou en variante, dans au moins un pixel, le caisson concentré peut comprendre une unique zone de gap intermédiaire et deux zones fort gap, avec la zone de gap intermédiaire qui forme un volume ouvert au centre et avec les deux zones fort gap respectivement autour et au centre de la zone de gap intermédiaire.

En complément ou en variante, dans au moins un pixel, le caisson concentré peut comprendre une pluralité de zones de gap intermédiaire, et une zone fort gap qui s'étend autour et entre les zones de gap intermédiaire.

De préférence, dans chaque pixel, la valeur minimale de concentration en cadmium dans le caisson concentré est strictement supérieure à la valeur minimale de concentration en cadmium dans la région dopée N.

Le dispositif de photo-détection selon l'invention comporte avantageusement une pluralité de pixels qui présentent tous une même longueur d'onde de coupure.

Le substrat semiconducteur peut présenter une topologie mésa, avec, dans chaque pixel, un plot mésa respectif recevant la région dopée P.

L'invention couvre également un procédé de fabrication d'un dispositif de photo-détection selon l'invention, qui comprend les étapes suivantes :
a) réalisation, sur le substrat semiconducteur, d'un revêtement structuré comportant au moins une ouverture traversante, avec ledit revêtement structuré qui comporte une couche riche en cadmium, constituée d'un alliage comprenant du cadmium et en contact physique direct avec le substrat semiconducteur;
b) recuit de l'ensemble comportant le substrat semiconducteur et le revêtement structuré ;
le procédé comprenant en outre la réalisation, dans chaque pixel, d'une jonction PN qui sépare la région dopée N et la région dopée P, avec la région dopée P située au regard de l'une au moins parmi l'au moins une ouverture traversante du revêtement structuré, et le recuit réalisant une inter-diffusion sélective du cadmium depuis le revêtement structuré vers la région dopée P de chaque pixel.

Dans chaque pixel, la réalisation de la jonction PN comporte avantageusement une étape d'injection d'éléments dopants dans le substrat semiconducteur, cette étape étant mise en oeuvre après l'étape a) et les éléments dopants étant injectés à travers l'au moins une ouverture traversante du revêtement structuré.

Le revêtement structuré peut comporter plusieurs couches superposées, parmi lesquelles une couche d'étanchéité, distincte de la couche riche en cadmium et apte à bloquer le passage d'éléments dopants vers l'intérieur du substrat semiconducteur.

De préférence, le procédé comporte en outre, pour chaque pixel, une étape de réalisation du plot de contact électrique mise en oeuvre après l'épreuve b), avec le plot de contact électrique qui s'étend dans chaque ouverture traversante du revêtement structuré dans ledit pixel.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
la figure 1A illustre de façon schématique un premier mode de réalisation d'un dispositif de photo-détection selon l'invention, selon une vue en coupe dans un plan transverse ;
la figure 1B illustre un exemple de répartition du cadmium dans le dispositif de la figure 1A ;
la figure 1C illustre de façon schématique le dispositif de la figure 1A, selon une vue en coupe dans un plan parallèle au substrat ;
les figures 2A, 2A', 2B, 2B', Fig. 2C, et 2C' illustrent de façon schématique différentes variantes du dispositif de la figure 1A ;
la figure 3 illustre de façon schématique un deuxième mode de réalisation d'un dispositif de photo-détection selon l'invention, selon une vue en coupe dans un plan transverse ;
les figures 4A, 4B, 4C, 4D, 4E, et 4F, illustrent les étapes d'un premier mode de réalisation de procédé selon l'invention, pour fabriquer un dispositif de photo-détection tel que celui de la figure 1A ;
les figures 5A, 5B, 5C, 5D, et 5E illustrent les étapes d'un deuxième mode de réalisation de procédé selon l'invention ;
la figure 6 illustre de façon schématique une première variante du procédé des figures 5A à 5E ;
la figure 7 illustre de façon schématique une deuxième variante du procédé des figures 5A à 5E ;
les figures 8A et 8B illustrent de façon schématique un troisième mode de réalisation de procédé selon l'invention ;
la figure 9A illustre de façon schématique un troisième mode de réalisation d'un dispositif de photo-détection selon l'invention, selon une vue en coupe dans un plan transverse ; et
la figure 9B illustre de façon schématique une variante du mode de réalisation de la figure 9A.

### EXPOSÉ DÉTAILLÉ DE MODES DE RÉALISATION PARTICULIERS

Dans toute la suite, une concentration moyenne en cadmium désigne une concentration volumique moyenne en atomes de cadmium.

Pour faciliter la lecture, on a représenté sur certaines des figures les axes d'un repère orthonormé (Oxyz).

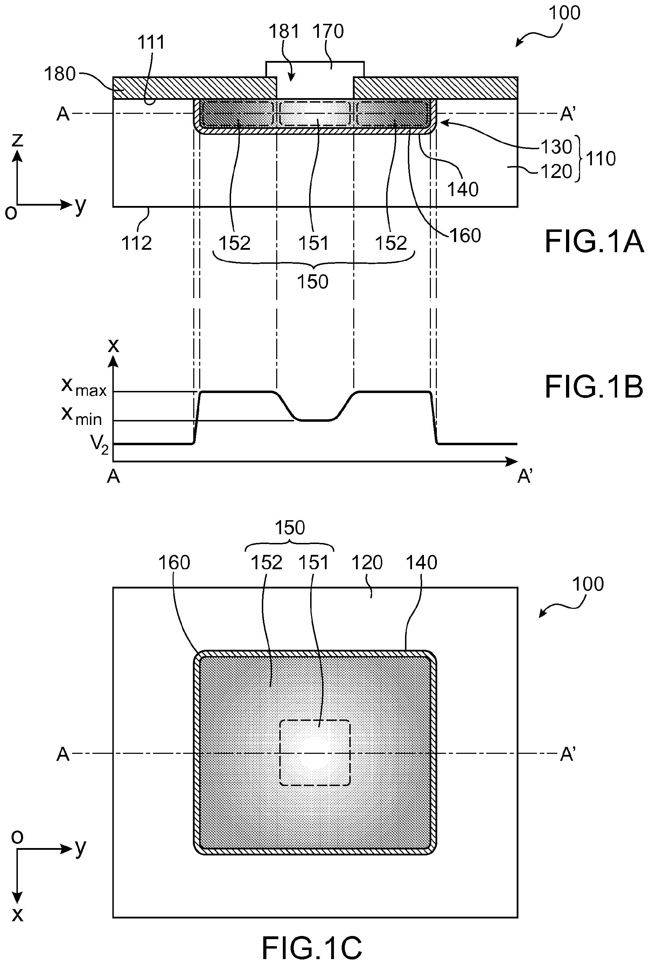

La figure 1A illustre, selon une vue en coupe dans un plan (yOz), un premier mode de réalisation de dispositif de photo-détection 100 selon l'invention.

Le dispositif de photo-détection 100 comporte un substrat 110 en matériau semi-conducteur, fait d'un alliage de cadmium, mercure et tellure de type CdₓHg₁₋ₓTe, avec x compris entre 0 et 1, bornes exclues. Le substrat 110 présente ici deux grandes faces parallèles au plan (xOy), qui définissent respectivement une face supérieure 111 et une face inférieure 112 du substrat 110 (substrat fin de type wafer).

Le substrat 110 est constitué ici par une région dopée N 120, et au moins une région dopée P 130. Chaque région dopée P 130, forme une jonction PN 140 respective avec la région dopée N 120. Chaque jonction PN 140 définit une photodiode, et chaque photodiode correspond à un pixel respectif du dispositif de photo-détection 100. Ici, le dispositif de photo-détection 100 comporte un unique pixel.

La région dopée N 120, forme une région dite d'absorption, dopée N ici par des ions indium. En fonctionnement, des photons incidents sur le dispositif de photo-détection 100 pénètrent dans le substrat 110, et forment une paire électron-trou dans la région dopée N 120. La région dopée N 120 présente une concentration en cadmium sensiblement constante sur tout son volume. Elle est constituée de CdₓHg₁₋ₓTe, avec x compris de préférence entre 0.15 et 0.95, par exemple x=0.3. La valeur de x est comprise par exemple entre 0.25 et 0.4 pour une sensibilité dans le moyen infrarouge (soit à des longueurs d'onde comprises entre 3 µm et 9 µm).

La région dopée P 130 est dopée P par des éléments dopants accepteurs appartenant de préférence à la colonne V du tableau périodique des éléments, par exemple de l'arsenic. La région dopée P 130 affleure la face supérieure 111 du substrat 110. Elle présente une forme de volume mince, avec une dimension réduite selon l'axe (Oz) de la profondeur dans le substrat 110 et de grandes dimensions selon les axes (Ox) et (Oy). De préférence, elle présente une profondeur au moins dix fois inférieure à son diamètre. Sa profondeur peut être comprise entre 100 nm et 1000 nm, par exemple égale à 200 nm. Son diamètre peut être compris entre 1 µm et 25 µm, par exemple égal à 10 µm. La région dopée P 130 est constituée de CdₓHg₁₋ₓTe, avec x compris de préférence entre 0.15 et 0.95. La valeur de x est variable, en fonction de l'emplacement considéré dans la région dopée P 130.

On définit un caisson concentré 150, localisé uniquement à l'intérieur de la région dopée P. Le caisson concentré 150 s'étend à l'intérieur de la région dopée P 130, depuis la face supérieure 111 du substrat 110 jusqu'à un fond du caisson, du côté opposé à ladite face supérieure du substrat. Le fond du caisson concentré est situé sensiblement au niveau de la jonction PN 140, de préférence à moins de 20 nm de cette dernière.

La concentration moyenne en cadmium dans le caisson concentré 150 est strictement supérieure à la concentration moyenne en cadmium dans la région dopée N 120. Ainsi, la concentration moyenne en cadmium dans le caisson concentré 150 correspond à une valeur V1 de x, la concentration moyenne en cadmium dans la région dopée N correspond à une valeur V2 de x, et V1 est strictement supérieure à V2. On a par exemple un rapport supérieur ou égal à 1.5 entre V1 et V2.

Le caisson concentré 150 présente un gradient de concentration en cadmium. En particulier, la valeur prise par x varie selon les axes (Ox) et (Oy), dans le caisson concentré 150 et dans des plans parallèles à la face supérieure 111 du substrat 110. Ledit gradient peut donc être nommé « gradient latéral ». La valeur prise par x varie dans le caisson concentré 150 entre une valeur supérieure xₘₐₓ et une valeur inférieure xₘᵢₙ strictement inférieure à xₘₐₓ.

La valeur supérieure xₘₐₓ est comprise de préférence entre 1.5 et 5 fois V2 (concentration moyenne en cadmium dans la région dopée N), voire entre 1.5 et 3 fois V2, tout en restant inférieure à l'unité. Avantageusement, elle reste comprise entre 0.15 et 0.95.

La valeur inférieure xₘᵢₙ est supérieure ou égale à la concentration minimale en cadmium dans la région dopée N, de préférence strictement supérieure à cette concentration minimale. En pratique, la concentration minimale en cadmium dans la région dopée N peut être égale à V2, la concentration moyenne en cadmium dans la région dopée N. Néanmoins, xₘᵢₙ ne doit pas dépasser un seuil limite au-delà duquel il se forme une barrière de potentiel bloquant la diffusion des porteurs de charge (dans les conditions normales de fonctionnement de la photodiode, lorsqu'une tension de polarisation est appliquée à cette dernière). De préférence, un rapport entre xₘᵢₙ et V2 est compris entre 1.1 et 3, plus préférentiellement entre 1.2 et 2.5.

Le gradient de concentration en cadmium permet de définir au moins une zone dite de gap intermédiaire 151 et au moins une zone dite fort gap 152, qui constituent ensemble le caisson concentré 150. Chaque zone fort gap 152 présente donc une concentration moyenne en cadmium qui correspond à une valeur V3 de x, chaque zone de gap intermédiaire 151 présente une concentration moyenne en cadmium qui correspond à une valeur V4 de x, et V3 est strictement supérieure à V4. De préférence, un rapport entre V3 et V4 est compris entre 1.2 et 5, de préférence entre 1.5 et 3. Ici, le caisson concentré 150 est constitué par une unique zone de gap intermédiaire 151 et une unique zone fort gap 152, avec l'unique zone de gap intermédiaire 151 entièrement entouré latéralement par l'unique zone fort gap 152.

Dans tout le texte, l'expression « entouré latéralement » signifie entouré dans des plans parallèles au plan du substrat.

Le substrat 110 comporte également une zone intermédiaire 160, qui s'étend ici latéralement (selon les axes (Ox) et (Oy)) et verticalement (selon l'axe (Oz)), entre le bord du caisson concentré 150 et la jonction PN 140. Dans cette zone intermédiaire, la concentration en cadmium décroît rapidement depuis une concentration en cadmium en bord de caisson concentré 150. La distance entre le bord du caisson concentré 150 et la jonction PN 140 définit une étendue de la zone intermédiaire 160. Cette étendue présente une valeur réduite, de préférence inférieure à 200 nm. Une telle zone intermédiaire 160 peut s'étendre d'un côté et/ou de l'autre de la jonction PN 140, dans la région dopée P et/ou dans la région dopée N. En tout état de cause, la zone intermédiaire occupe moins de 10% du volume de la région dopée P, et le caisson concentré occupe plus de 90% du volume de la région dopée P. Dans toute la suite, on néglige la présence de cette zone intermédiaire 160, et on considère, pour simplifier, que le caisson concentré 150 s'étend sur tout le volume de la région dopée P.

A la figure 1C, on a représenté le dispositif de photo-détection 100, selon une vue en coupe dans un plan parallèle au plan (xOy) passant par le caisson concentré 150. On observe bien la zone de gap intermédiaire 151 entièrement entourée par la zone fort gap 152, ainsi que la fine zone intermédiaire 160 entre le caisson concentré 150 et la région dopée N 120.

Le substrat 110 est recouvert, du côté de sa face supérieure 111, par un revêtement structuré 180 qui s'étend directement sur le substrat 110. Le revêtement structuré 180 comporte au moins une ouverture traversante par pixel, ici une et unique ouverture traversante 181 dans le pixel. Chaque pixel comporte autant d'ouverture(s) traversante(s) que de zone(s) de gap intermédiaire dans le caisson concentré, chaque ouverture traversante étant située au regard d'une zone de gap intermédiaire respective dudit caisson.

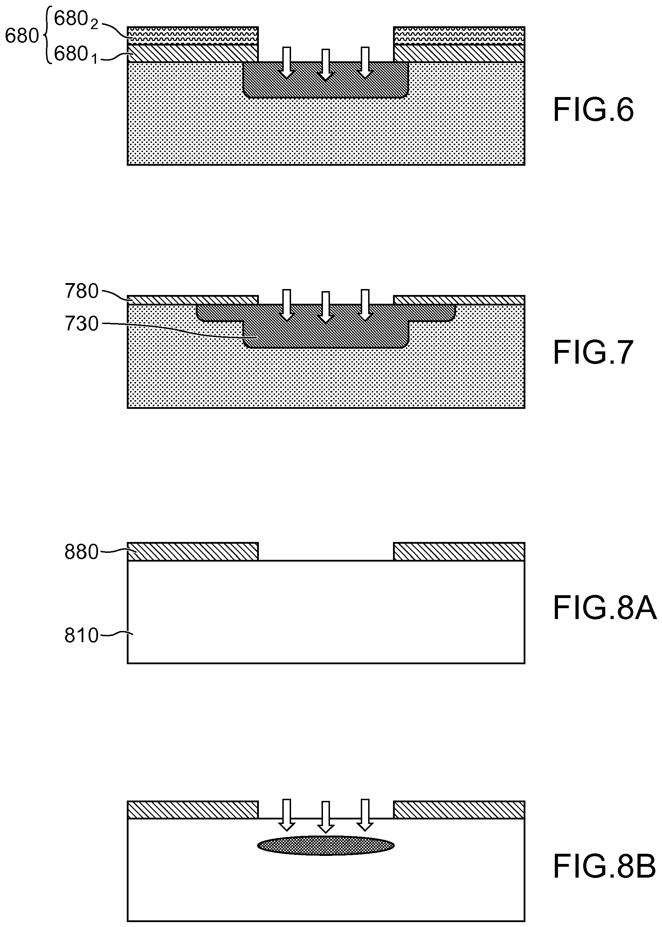

Le revêtement structuré 180 comporte une couche riche en cadmium, constituée d'un alliage comprenant du cadmium, par exemple du CdTe, du CdS, du CdSe, du CdZnSe, etc. Cette couche riche en cadmium s'étend directement sur le substrat 110, en contact physique direct avec ce dernier. Ici, le revêtement structuré 180 est constitué de cette seule couche riche en cadmium. Dans des variantes non représentées, il peut comporter d'autres couches, notamment une couche d'étanchéité apte à bloquer le passage d'éléments dopants vers l'intérieur du substrat (voir figure 6).

Chaque pixel comporte également un plot de contact électrique 170, en contact physique direct avec chaque zone de gap intermédiaire du caisson concentré appartenant au même pixel. Dans chaque pixel, le plot de contact électrique 170 s'étend du côté de la face supérieure 111 du substrat 110, en pénétrant dans chaque ouverture traversante 181 du revêtement structuré pour venir au contact de la zone de gap intermédiaire 151 correspondante.

Dans chaque ouverture traversante 181, le plot de contact électrique 170 peut recouvrir tout ou partie de la surface du substrat laissée libre par cette dernière. De préférence, le plot de contact électrique 170 remplit entièrement chaque ouverture traversante 181 du revêtement structuré dans le pixel. Dans chaque ouverture traversante 181, le plot de contact électrique 170 peut reposer contre la face supérieure 111 du substrat 110, ou s'enfoncer légèrement dans la zone de gap intermédiaire. En outre, le plot de contact électrique 170 peut s'étendre uniquement à l'intérieur de l'ouverture traversante 181, ou dépasser jusque sur le dessus du revêtement structuré 180. Lorsque le pixel comporte plusieurs zones de gap intermédiaire et plusieurs ouvertures traversantes, le plot de contact électrique comporte des portions de contact situées dans lesdites ouvertures traversantes et une ou plusieurs portion(s) de raccord située(s) entre lesdites ouvertures traversantes et sur le dessus du revêtement structuré 180.

Dans chaque pixel du dispositif de photo-détection selon l'invention, chaque zone de gap intermédiaire 151 du caisson concentré est donc surmontée par une ouverture traversante 181 respective du revêtement structuré, et en contact physique direct avec le plot de contact électrique 170 à travers ladite ouverture traversante 181.

En fonctionnement, la zone de charge d'espace s'étend de part et d'autre de la jonction PN 140, pour partie dans le caisson concentré 150. Grâce à la plus forte concentration moyenne en cadmium dans le caisson concentré 150, le dispositif de photo-détection 100 peut détecter des photons à de grandes longueurs d'onde tout en présentant un courant d'obscurité réduit. Dans chaque pixel, la collecte des porteurs de charge est réalisée au niveau de l'au moins une zone de gap intermédiaire 151, reliée au plot de contact électrique 170. Par conséquent, la présence éventuelle d'une barrière de potentiel au niveau de la zone fort gap 152 n'empêche pas une collecte efficace des porteurs de charge. On peut donc augmenter une valeur moyenne du gap dans la zone de charge d'espace, en comparaison avec l'art antérieur, et ainsi réduire encore le courant d'obscurité pour une même gamme de sensibilité spectrale. On peut en outre relâcher les tolérances de fabrication, puisque la valeur du gap n'est un paramètre sensible que dans une partie seulement du caisson concentré.

A la figure 1B, on a représenté un exemple d'évolution de la concentration en cadmium x, le long d'un axe AA' s'étendant dans un plan parallèle au plan (xOy) et passant par le caisson concentré 150. On observe sur la figure 1B deux transitions brutales entre la valeur basse V2 et la valeur xₘₐₓ, aux intersections entre l'axe AA' et la zone intermédiaire 160. Dans cet exemple, la concentration en cadmium est constante à la valeur V2, dans tout le volume de la région dopée N diminué du volume de recouvrement entre la région dopée N et la zone intermédiaire. Dans le caisson concentré, la concentration x présente deux paliers à la valeur xₘₐₓ, encadrant une zone à fort gradient dans laquelle la concentration x passe de la valeur xₘₐₓ à la valeur xₘᵢₙ, puis de la valeur xₘᵢₙ à la valeur xₘₐₓ. On peut avoir un palier à la valeur xₘᵢₙ.

On peut considérer que la zone de gap intermédiaire correspond aux portions du caisson concentré dans lesquelles x est compris entre xₘᵢₙ et une valeur seuil strictement inférieure à xₘₐₓ. La zone fort gap correspond alors au restant du caisson concentré. De même, la zone fort gap peut correspondre aux portions du caisson concentré dans lesquelles x est sensiblement égal à xₘₐₓ. La zone fort gap s'étend alors au regard des portions pleines du revêtement structuré, tandis que chaque zone de gap intermédiaire s'étend au regard d'une ouverture traversante respective du revêtement structuré. Il est bien entendu que l'on pourra définir autrement les zones de gap intermédiaire et fort gap, par exemple pour que la zone fort gap s'étende également au regard de régions périphériques des ouvertures traversantes. En tout état de cause, il est avantageux que le volume du caisson concentré à la concentration xₘₐₓ soit le plus élevé possible, et occupe par exemple plus de la moitié du volume de la région dopée P de manière à réduire au maximum le courant d'obscurité.

Dans ce premier mode de réalisation, une surface de recouvrement entre la région dopée P et le revêtement structuré est non nulle. Dans un cas extrême, cette surface de recouvrement peut être nulle. Dans ce cas, les bords de la région dopée P peuvent être directement adjacents aux bords d'une ouverture traversante du revêtement structuré, au niveau de la face supérieure 111 du substrat 110. En tout état de cause, cette surface de recouvrement est une surface comprise entre un minimum et un maximum, où ce minimum peut prendre la valeur nulle, et où le maximum est avantageusement égal à la surface de la région dopée P affleurant la face supérieure du substrat diminuée de 0,5 µm².

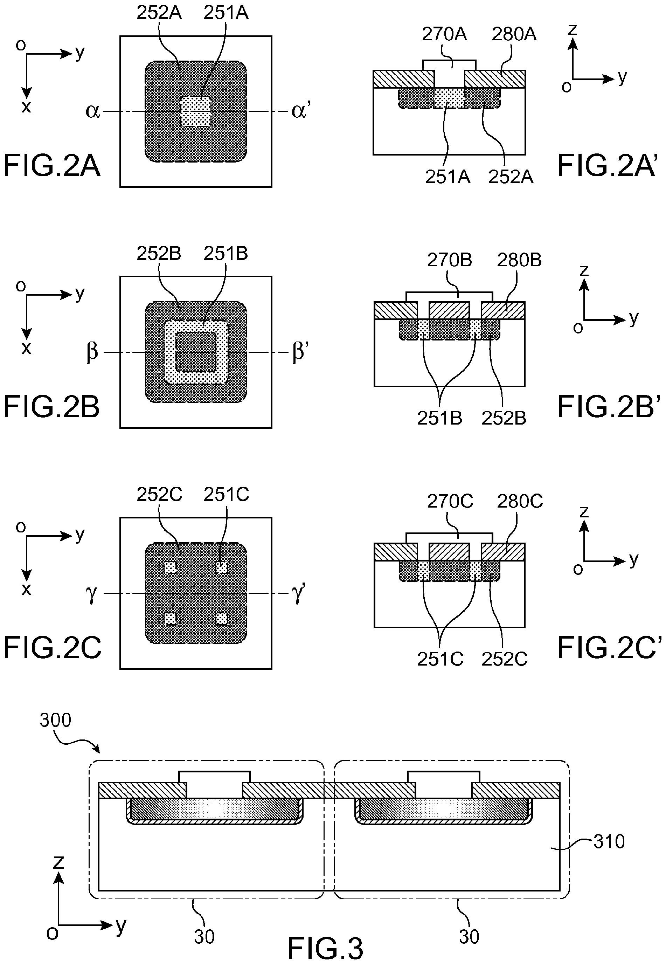

Les figures 2A, 2A' à 2C, 2C' illustrent de façon schématique différentes variantes de répartition des zones de gap intermédiaire et fort gap dans un pixel du dispositif selon l'invention.

Aux figures 2A et 2A', les zones de gap intermédiaire et fort gap sont réparties comme dans l'exemple de la figure 1A. La figure 2A est une vue en coupe du pixel, dans un plan (x0y) parallèle au plan du substrat. La figure 2A' est une vue en coupe du même pixel, dans un plan (y0z) orthogonal au plan du substrat et passant par l'axe αα'. Dans cette variante, le caisson concentré est constitué par une unique zone de gap intermédiaire 251A et une unique zone fort gap 252A. La zone de gap intermédiaire 251A s'étend au centre du caisson concentré, entièrement entourée latéralement par la zone fort gap 252A. Le revêtement structuré 280A comporte une unique ouverture traversante, située au regard de la zone de gap intermédiaire 251A. Le plot de contact électrique 270A remplit cette unique ouverture traversante. Cette variante permet de limiter au maximum le volume de la zone de gap intermédiaire, et permet d'assurer une collecte optimale des porteurs de charge et un courant d'obscurité minimal.

Aux figures 2B et 2B', le caisson concentré est constitué d'une unique zone de gap intermédiaire 251B et de deux zones fort gap 252B. La figure 2B est une vue en coupe du pixel, dans un plan (x0y) parallèle au plan du substrat. La figure 2B' est une vue en coupe du même pixel, dans un plan (y0z) orthogonal au plan du substrat et passant par l'axe ββ'. La zone de gap intermédiaire 251B forme un volume ouvert au centre, centré sur le pixel. Les zones fort gap 252B s'étendent respectivement à l'intérieur et autour de ce volume ouvert au centre. Le revêtement structuré 280B comporte une unique ouverture traversante, qui entoure une portion pleine du revêtement structuré et qui est située au regard de la zone de gap intermédiaire 251B. Le plot de contact électrique 270B remplit cette unique ouverture traversante. La collecte des porteurs de charge s'effectue dans la zone de gap intermédiaire, en périphérie du pixel. De manière contre-intuitive, ce positionnement des zones de collecte favorise une bonne fonction de transfert de modulation.

Aux figures 2C et 2C', le caisson concentré est constitué de quatre zones de gap intermédiaire distinctes 251C et d'une zone fort gap 252C. La figure 2C est une vue en coupe du pixel, dans un plan (x0y) parallèle au plan du substrat. La figure 2C' est une vue en coupe du même pixel, dans un plan (y0z) orthogonal au plan du substrat et passant par l'axe γγ'. Les zones de gap intermédiaire 251C s'étendent respectivement aux quatre coins du pixel. La zone fort gap 252C s'étend entre et autour des zones de gap intermédiaire 251C. Le revêtement structuré 280C comporte quatre ouvertures traversantes, chacune au regard d'une zone de gap intermédiaire 251C respective. Le plot de contact électrique 270C remplit ces quatre ouvertures traversantes et recouvre également une partie revêtement structuré. Cette variante permet de combiner une bonne fonction de transfert de modulation et un courant d'obscurité minimal, grâce à un positionnement des zones de gap intermédiaire en périphérie du pixel et sur un volume réduit. Selon des variantes non représentées, le pixel présente une forme non carrée, avec toujours une zone de gap intermédiaire respective à chaque coin du pixel.

Dans chacune de ces variantes, la répartition des ouvertures traversantes dans le revêtement structuré est similaire à la répartition des zones de gap intermédiaire, avec au moins une ouverture traversante dans chaque pixel du dispositif de photo-détection. Une ouverture traversante peut entourer une portion pleine du revêtement structuré.

La figure 3 illustre de façon schématique un deuxième mode d'un dispositif de photo-détection 300 selon l'invention, selon une vue en coupe dans un plan (yOz). Ce deuxième mode de réalisation ne diffère du premier mode de réalisation qu'en ce qu'il comporte plusieurs pixels 30, partageant le même substrat 310. Tous les pixels 30 sont surmontés par un même jeu d'au moins une ouverture traversante dans le revêtement structuré. En particulier, chacun des jeux d'au moins une ouverture traversante comporte un même nombre d'ouverture(s) traversante(s), répartie(s) de la même manière sur le pixel, avec les mêmes dimensions d'un pixel à l'autre. Tous les pixels 30 présentent en outre la même longueur d'onde de coupure, avec une même valeur de la concentration minimale en cadmium dans la région dopée N.

Dans les différents exemples illustrés ci-dessus, la région dopée P présente une section sensiblement carrée dans un plan (x0y) parallèle au plan du substrat. Cet exemple n'est pas limitatif, et de nombreuses autres formes de région dopée P peuvent être mises en oeuvre sans sortir du cadre de la présente invention, par exemple une région dopée P de section ronde ou ovale dans un plan (x0y) parallèle au plan du substrat. De la même manière, l'au moins une ouverture traversante située au regard de la région dopée P, dans le revêtement structuré, peut présenter une section autre que carrée, par exemple ronde ou ovale, dans un plan (x0y) parallèle au plan du substrat. En tout état de cause, la section de l'ouverture traversante est de préférence une homothétie de la section de la région dopée P. De la même manière, l'invention n'est pas limitée à un ou des pixels de section carrée dans un plan (x0y) parallèle au plan du substrat.

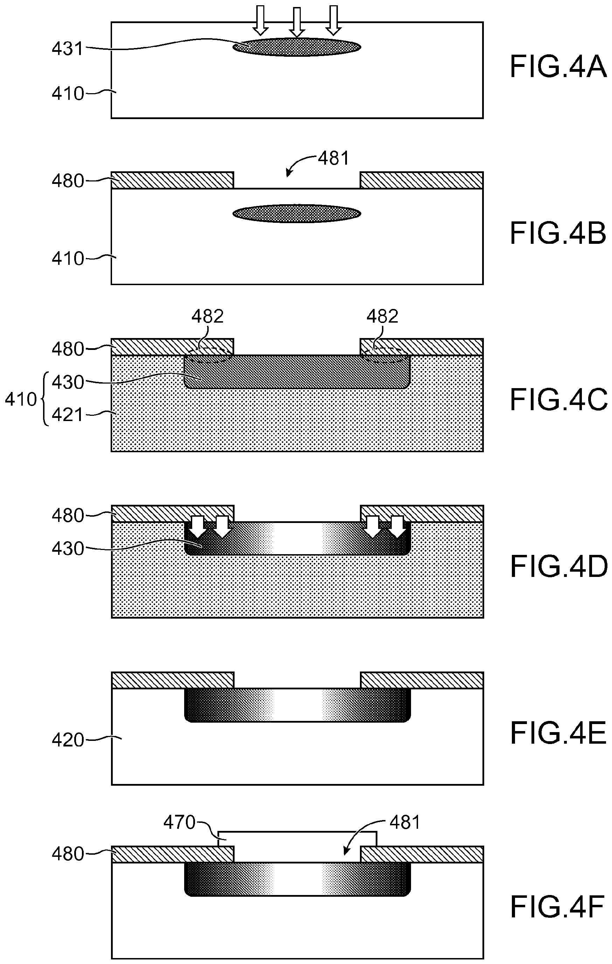

On va maintenant décrire, en référence aux figures 4A à 4F, les étapes d'un premier mode de réalisation de procédé pour fabriquer un dispositif de photo-détection selon l'invention.

Dans une première étape, on réalise une implantation ionique d'éléments dopants dans un substrat semiconducteur 410 en CdₓHg₁₋ₓTe (figure 4A). Le substrat 410 présente initialement un dopage de type N sur tout son volume, réalisé par exemple par des ions indium. Les éléments dopants implantés sont de type accepteur, par exemple de l'arsenic ou tout autre élément appartenant à la colonne V du tableau périodique des éléments (phosphore, antimoine, bismuth, etc). Les conditions d'implantation sont standard, par exemple une énergie de 500 keV et une dose d'implantation de 2.10¹⁵ atomes/cm². On obtient ainsi une zone d'implantation 431 dans le substrat 410. Les éléments dopants sont implantés dans le substrat au niveau d'une face dite supérieure de ce dernier.

On réalise ensuite (figure 4B), sur la face supérieure du substrat 410, un revêtement structuré 480 tel décrit ci-dessus. Le revêtement structuré est constitué ici de CdTe, et comporte au moins une ouverture traversante 481.

Le revêtement structuré 480 peut être réalisé par dépôt ou épitaxie d'une couche pleine, puis gravure au travers d'un masque de gravure pour former l'au moins une ouverture traversante 481. La gravure peut être une gravure chimique à l'aide d'une solution de Brome, dans laquelle on ajuste la profondeur de gravure en ajustant une durée de la gravure chimique, ou une gravure chimique sélective, dans laquelle le substrat 410 n'est pas sensible à la gravure, ou une gravure sèche de type ionique ou plasma, etc. Le masque de gravure est typiquement en résine. Selon d'autres variantes, le revêtement structuré 480 est réalisé à l'aide d'un masque de résine, déposé directement sur le substrat puis recouvert de CdTe. Lorsque l'on retire le masque de résine, on retire en même temps le CdTe hormis aux emplacements des ouvertures dans le masque de résine, ce qui forme sur le substrat une couche structurée en CdTe (technique de lift-off).

On réalise ensuite un recuit de diffusion et activation des éléments dopants accepteurs. Ce recuit se fait à environ 400°C, et forme des lacunes de mercure dans tout le substrat. A l'issue du recuit, le substrat 410 est donc constituée par une région 421, faiblement dopée P en raison des lacunes de mercure, et au moins une région dopée P 430, fortement dopée P grâce aux éléments dopants accepteurs. Sur la figure 4C, on a identifié la surface de recouvrement 482 entre la région dopée P 430 et les portions pleines du revêtement structuré 480.

On réalise ensuite un recuit d'inter-diffusion du cadmium (figure 4D), au cours duquel les atomes de cadmium du revêtement structuré 480 diffusent vers le substrat (et des atomes de mercure du substrat diffusent vers le revêtement structuré 480). Ce recuit est réalisé de préférence à une température supérieure à 100°C, mais inférieure à 500°C par exemple à une température égale à 300°C. Ce recuit est réalisé pendant une durée supérieure à une minute, de préférence supérieure à 24 heures, par exemple entre 30 heures et 50 heures.

La diffusion du cadmium est une diffusion ionique, isotrope, avec une longueur de diffusion qui fait intervenir un terme d'accélération dû au niveau de Fermi. Pour un matériau dopé P, ce terme augmente avec la densité de porteurs. (Pour un matériau intrinsèque ou dopé N, ce terme prend la valeur 1, et donc n'intervient pas.). Le cadmium diffuse donc quasiment uniquement dans la région dopée P 430, où la densité de porteurs est très forte en comparaison avec la région 421 faiblement dopée P (puis dopée N à l'issu d'un recuit sous pression saturante de vapeur de mercure, tel que décrit ci-après en référence à la figure 4E). On parle donc d'une inter-diffusion sélective. Le cadmium diffuse dans le substrat depuis la surface de recouvrement 482 entre la région dopée P et le revêtement structuré 480. Il se forme donc, dans la région dopée P 430, un caisson concentré avec un gradient latéral de cadmium. Le caisson concentré est automatiquement localisé dans la région dopée P, grâce au caractère sélectif de l'inter-diffusion du cadmium (la diffusion du cadmium vers la région dopée N existe, mais elle est négligeable au regard de la diffusion du cadmium vers la région dopée P). Dans le caisson concentré, la concentration en cadmium est maximale au regard de la surface de recouvrement 482 entre la région dopée P et le revêtement structuré 480, puis décroît au fur et à mesure que l'on s'éloigne de cette surface de recouvrement 482. Le gradient latéral de concentration en cadmium permet de définir au moins une zone de gap intermédiaire et au moins une zone fort gap dans le caisson concentré.

Le niveau de cadmium, et donc le gap dans le caisson concentré, est déterminé par la quantité de cadmium disponible dans le revêtement structuré, les dimensions de la surface de recouvrement entre la région dopée P et le revêtement structuré, et le bilan thermique associé au recuit d'inter-diffusion (durée et température, définissant des longueurs de diffusion du cadmium). La quantité de cadmium disponible dans le revêtement structuré et les dimensions de la surface de recouvrement définissent notamment un seuil maximal de niveau de gap dans le caisson concentré, qui ne peut en aucun cas être dépassé. Cet effet de seuil rend également très reproductible le gradient de gap dans le caisson concentré. On peut notamment obtenir un gap minimal dans le caisson concentré qui est identique pour l'ensemble des pixels d'un même dispositif de photo-détection, et d'un dispositif de photo-détection à l'autre. On assure ainsi une grande homogénéité des performances en détection, d'un pixel à l'autre d'un même dispositif, même pour des dispositifs de grandes dimensions avec de très nombreux pixels. De même, on peut assurer une grande homogénéité des performances en détection, d'un dispositif à l'autre.

Grâce aux ouvertures traversantes dans le revêtement structuré, le niveau de cadmium dans le caisson concentré augmente plus lentement que si le recuit était réalisé avec une couche pleine de CdTe. En particulier, un débit de la diffusion des atomes de cadmium, depuis le revêtement structuré vers la région dopée P, est fonction des dimensions de la surface de recouvrement 482 entre le revêtement structuré 480 et la zone dopée P 430. Il sera donc plus facile de s'assurer que le gap dans la zone de gap intermédiaire ne dépasse pas un seuil limite au-delà duquel il forme une barrière de potentiel pour les porteurs de charge, puisque ce seuil limite sera atteint plus tard, pour une durée du recuit plus importante et/ou une température du recuit plus élevée. Le procédé de fabrication est donc particulièrement robuste, grâce notamment à un relâchement des contraintes sur le contrôle des conditions du recuit d'inter-diffusion.

On réalise ensuite un nouveau recuit, sous pression saturante de vapeur de mercure (figure 4E). Ce nouveau recuit permet de combler les lacunes de mercure dans la région 421. A l'issue de ce recuit, la région 421 présente un dopage N et forme la région dopée N 420 telle que décrite en référence à la figure 1A. Ce nouveau recuit est réalisé à une température comprise entre 150 °C et 350 °C, par exemple 250 °C.

Ensuite, on réalise une métallisation dans l'ouverture 481 pour former le plot de contact électrique 470 (figure 4F). Le plot de contact électrique 470 se trouve ainsi automatiquement aligné avec la zone faible gap, pour la collecte des porteurs de charge.

On obtient ainsi un dispositif de photo-détection selon l'invention. Le revêtement structuré est avantageusement conservé dans le dispositif final, pour former une couche de passivation.

Pour des raisons de clarté, on a distingué ici trois recuits, réalisant respectivement la diffusion et activation des éléments dopants, l'inter-diffusion du cadmium, et le comblement des lacunes de mercure. Il se peut que l'un et/ou l'autre parmi le recuit de diffusion et activation des éléments dopants et le recuit de comblement des lacunes de mercure participe également à l'inter-diffusion du cadmium. Dans ce cas, le niveau de cadmium dans le caisson concentré est déterminé notamment par le bilan thermique associé aux plusieurs recuits qui participent à l'inter-diffusion du cadmium. Le cas échéant, un même recuit réalise au moins deux fonctions parmi la diffusion des éléments dopants, l'activation des éléments dopants, l'inter-diffusion du cadmium, et le comblement des lacunes de mercure.

Le procédé selon l'invention ne nécessite qu'un nombre réduit d'étapes, sans contrainte forte d'alignement. En particulier, le caisson concentré est automatiquement localisé dans la zone dopée P, et le plot de contact électrique est automatiquement aligné sur la zone de gap intermédiaire du caisson concentré. On obtient ainsi une très bonne uniformité des performances du dispositif de photo-détection, d'un pixel à l'autre d'un même dispositif, ainsi qu'une très bonne reproductibilité de ces performances d'un dispositif à l'autre.

Les différents recuits, et plus particulièrement le recuit d'inter-diffusion, n'ont pas d'influence sur la longueur d'onde de coupure du dispositif de photo-détection obtenu en fin de procédé. En effet, les atomes de cadmium du revêtement structuré ne diffusent quasiment pas dans la région dopée N, et le cas échéant restent localisés à proximité de la face supérieure du substrat.

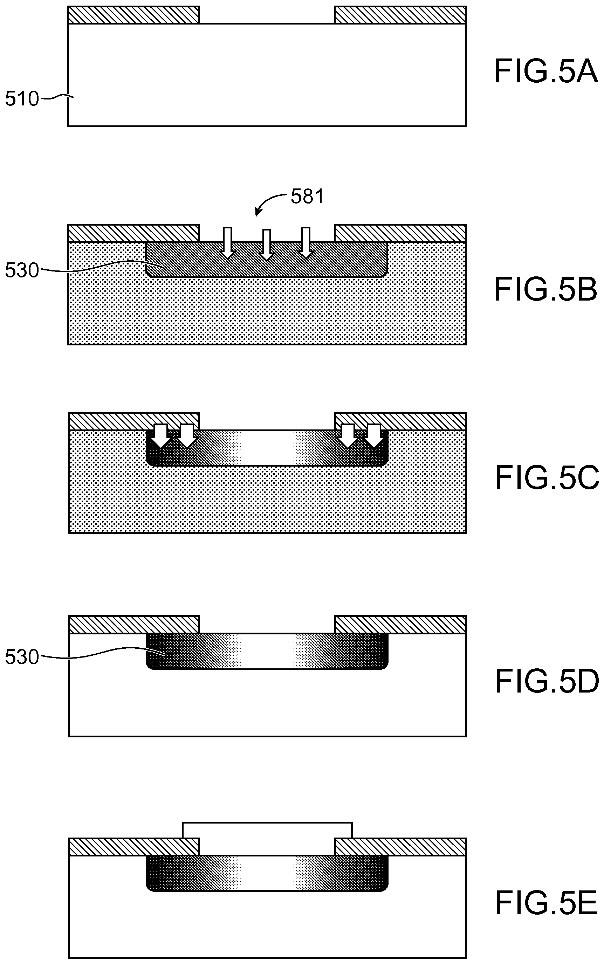

Les figures 5A à 5E illustrent les étapes d'un deuxième mode de réalisation de procédé selon l'invention, qui ne sera décrit que pour ses différences relativement au procédé des figures 4A à 4B.

Ici, on commence par réaliser le revêtement structuré 580 sur le substrat 510 (figure 5A). Ensuite, on injecte des éléments dopants dans le substrat 510, au travers de l'ouverture traversante 581 du revêtement structuré 580 (figure 5B).

Ici, les éléments dopants sont injectés dans le substrat 510 à l'aide d'un recuit sous pression saturante d'éléments dopants en phase vapeur. Ce recuit réalise l'injection des éléments dopants dans le substrat, et leur diffusion à l'intérieur du substrat. Ici, ce recuit réalise également l'activation des éléments dopants dans le substrat. En variante, l'activation des éléments dopants est réalisée par un recuit distinct. La région dopée P 530 ainsi obtenue est donc alignée automatiquement avec l'ouverture traversante 581 du revêtement structuré 580. La région dopée P 530 est ici légèrement plus large que l'ouverture traversante 581, en raison de la diffusion des éléments dopants dans le substrat.

Ensuite, les étapes des figures 5C à 5E correspondent respectivement aux étapes des figures 4D à 4F décrites ci-dessus.

Ce deuxième mode de réalisation offre un alignement automatique de l'ouverture traversante du revêtement structuré relativement à la région dopée P, particulièrement avantageux pour des pas de pixel réduits (par exemple inférieurs ou égal à 10 µm, ce qui est souvent le cas en imagerie infrarouge). En outre, le dopage par recuit sous pression saturante d'éléments dopants en phase vapeur évite la création de défauts dans le substrat.

Lorsque le revêtement structuré est utilisé comme masque pour l'injection d'éléments dopants dans le substrat, on peut distinguer différents cas :
Cas 1 : Le revêtement structuré est constitué uniquement du matériau riche en cadmium, et empêche la diffusion des éléments dopants jusque dans le substrat (par exemple grâce à une forte épaisseur et/ou une étanchéité aux éléments dopants en phase vapeur). C'est la situation illustrée en figure 5B.
Cas 2 : Le revêtement structuré comporte deux couches superposées, comme illustré à la figure 6. Une première couche 680₁, riche en cadmium, recouvre directement la face supérieure du substrat et fournit les atomes de cadmium qui vont diffuser dans le substrat. Une seconde couche 680₂, nommée couche d'étanchéité, recouvrant la première couche 680₁ et étanche aux éléments dopants en phase vapeur. La seconde couche 680₂ n'est pas constituée du même ensemble de composés chimiques que la première couche 680₁. La seconde couche 680₂ est constituée par exemple de ZnS, ou de SiOₓ. Elle peut être formée par un masque de gravure utilisé pour graver des ouvertures traversantes dans la couche 680₁ riche en cadmium. La seconde couche 680₂ peut être conservée dans le dispositif final, ou retirée après l'injection des éléments dopants dans le substrat.
Cas 3 : Dans ce cas 3, la région dopée P est réalisée par implantation ionique. Le revêtement est constitué uniquement du matériau riche en cadmium. Il n'est pas étanche aux éléments dopants en phase vapeur, mais il constitue une épaisseur supplémentaire à traverser pour les éléments dopants en phase vapeur. La région dopée P reproduit donc la topologie du revêtement structuré 780, ici avec une partie centrale à profondeur nominale et une partie périphérique à profondeur réduite (voir figure 7).

Les figures 8A et 8B illustrent les premières étapes d'un troisième mode de réalisation de procédé selon l'invention, qui ne sera décrit que pour ses différences relativement au procédé des figures 4A à 4B. Là encore, une étape de réalisation du revêtement structuré 880 (figure 8A) est mise en oeuvre préalablement à l'injection des éléments dopants dans le substrat 810 (figure 8B), de manière à réaliser un alignement automatique de chaque ouverture traversante du revêtement structuré avec une région dopée P respective. Ici, l'injection d'éléments dopants est réalisée par injection ionique. Les étapes suivantes ne sont pas illustrées, et correspondent aux étapes des figures 4C à 4F. Là encore, le revêtement structuré peut comporter une couche étanche aux éléments dopants, ou n'être que partiellement étanche aux éléments dopants de sorte que la région dopée P reproduit *in fine* la topologie du revêtement structuré.

Dans les différents exemples illustrés ci-dessus, le dispositif de photo-détection présente une configuration planaire, avec un substrat dont des faces inférieure et supérieure sont planes et parallèles entre elles. Lorsque le dispositif de photo-détection comporte plusieurs pixels, ces derniers forment ensemble une matrice planaire de pixels.

En variante, le dispositif de photo-détection selon l'invention peut présenter une configuration dite mésa, dans laquelle chaque pixel se présente sous la forme d'un plot dit mésa, entouré de tranchées. Lorsque le dispositif de photo-détection comporte plusieurs pixels, ces derniers forment ensemble une matrice mésa de pixels. L'agencement matrice mésa est avantageusement combiné avec un caisson concentré tel que représenté en figures 2A et 2A', pour obtenir à la fois une bonne fonction de transfert de modulation aux mésas, et un très faible niveau de bruit grâce à volume minimal de la zone de gap intermédiaire.

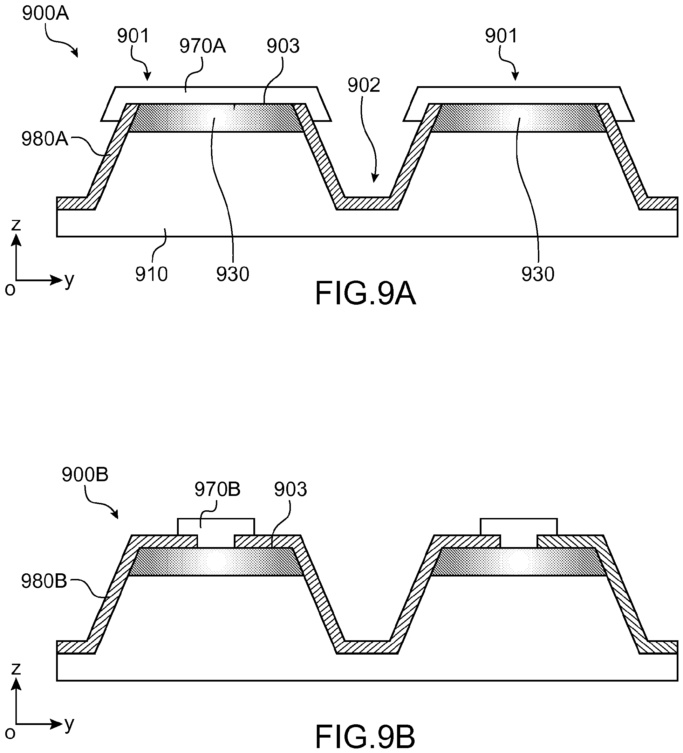

Les figures 9A et 9B illustrent deux exemples de dispositifs de photo-détection selon l'invention, avec une configuration mésa, et selon une vue en coupe dans un plan parallèle au plan (y0z). Ces deux exemples ne seront décrits que pour leur différence avec les premier et deuxième modes de réalisation décrits ci-avant.

Dans le mode de réalisation de la figure 9A, le substrat 910 ne diffère du substrat décrit en référence à la figure 1A qu'en ce qu'il présente une topologie mésa, avec ici deux plots mésa 901 séparés par une tranchée 902. Chaque plot mésa 901 définit un pixel respectif du dispositif de photo-détection 900A. Chaque plot mésa 901 comporte une base, du côté du fond des tranchées, et un sommet, du côté opposé à la base. Une interface entre le plot mésa et le milieu environnant, du côté du sommet du plot mésa, est une surface plane 903 parallèle au plan (x0y).

Chaque plot mésa comporte une région dopée P 930 respective, au niveau du sommet du plot mésa. La région dopée P 930 comporte un caisson concentré tel que décrit ci-avant. Ici, le revêtement structuré 980A recouvre les flancs des plots mésa et le fond des tranchées, en laissant libre l'intégralité des surfaces planes 903 respectives, au sommet des plots mésa. Dans chaque pixel, le plot de contact électrique 970B est en contact physique direct avec l'intégralité de la surface plane 903 du même pixel, ici en recouvrant également une partie du revêtement structuré.

Le procédé de fabrication du dispositif de photo-détection 900A est décrit brièvement ci-après. On part d'un substrat planaire de type wafer, sur lequel on dépose un masque de résine. On grave le substrat planaire à travers le masque de résine, pour y former les tranchées séparant les plots mésa (gravure ionique ou chimique). L'ensemble obtenu est recouvert d'une couche pleine riche en cadmium, plus le cas échéant une couche pleine étanche à des éléments dopants. En retirant le masque de résine, on obtient un ensemble constitué du substrat et du revêtement structuré, avec le substrat qui présente une topologie mésa et le revêtement structuré qui recouvre uniquement le fond des tranchées et les flancs des plots mésa (technique de lift-off). Le procédé comporte également la réalisation des jonctions PN, séparant chacune une région dopée P respective au sommet d'un plot mésa, et une région dopée N incluant les bases des plusieurs plots mésa. L'injection d'éléments dopants dans le substrat peut être réalisée après retrait du masque de résine, ou avant la gravure du substrat planaire (dans ce second cas, on peut réaliser un substrat planaire dont toute une zone supérieure est dopée P, et les plusieurs régions dopées P sont délimitées lors de la gravure des plots mésa). Le procédé comporte également une étape de recuit de l'ensemble constitué du substrat et du revêtement structuré, avec le substrat qui présente une topologie mésa et le revêtement structuré qui recouvre uniquement le fond des tranchées et les flancs des plots mésa. Lors de ce recuit, le cadmium du revêtement structuré diffuse vers les régions dopées P, depuis des surfaces situées sur les flancs des plots mésa correspondant.

La figure 9B illustre une variante du mode de réalisation de la figure 9A. Le dispositif de photo-détection 900B de la figure 9B ne diffère de celui de la figure 9A qu'en ce que le revêtement structuré 980B recouvre les flancs des plots mésa, le fond des tranchées, et une zone périphérique de la surface plane 903 au sommet du plot mésa, en ne laissant libre qu'une zone centrale de ladite surface plane 903. Le plot de contact électrique 970B est en contact physique direct avec ladite zone périphérique de la surface plane 903, ici en recouvrant également une partie du revêtement structuré.

Un procédé de fabrication associé à la variante de la figure 9B est similaire aux procédés décrits ci-avant en référence aux figures 4A à 8B, hormis une étape supplémentaire préliminaire de gravure d'un substrat planaire pour y former des plots mésa séparés par des tranchées.

La variante de la figure 9B correspond à l'exemple des figures 2A et 2A', dans une topologie mésa. De nombreuses autres variantes peuvent être mises en oeuvre, avec dans chaque pixel une ou plusieurs ouvertures traversantes dans le revêtement structuré, par exemple des variantes correspondant aux exemples des figures 2B, 2B', respectivement 2C, 2C', dans une topologie mésa.

L'invention propose ainsi un dispositif à au moins une photodiode P/N, dans lequel chaque photodiode comporte une hétérostructure en trois dimensions (caisson concentré) à gradient de gap latéral. L'invention propose également un procédé de fabrication d'un tel dispositif, à l'aide d'une couche structurée formant réservoir de cadmium et d'un recuit d'inter-diffusion sélectif.

L'invention n'est pas limitée aux exemples de dispositifs et procédés décrits ci-avant, et de nombreuses variantes peuvent être mises en oeuvre sans sortir du cadre de l'invention, par exemple avec un nombre différent de zone(s) de gap intermédiaire dans le caisson concentré répartie(s) de différentes façons dans ce dernier. Selon d'autres variantes encore, l'ouverture traversante dans le revêtement structuré est fortement décentrée relativement à la région dopée P, de sorte que la zone de gap intermédiaire n'est pas entourée par la zone fort gap, mais simplement adjacente à cette dernière. Le substrat en CdₓHg₁₋ₓTe peut reposer sur un support, avantageusement transparent aux longueurs d'onde à détecter.

## Revendications

1. Dispositif de photo-détection (100 ; 300 ; 900A ; 900B) à au moins un pixel, comportant un substrat semiconducteur (110 ; 310 ; 410 ; 510 ; 810) en CdₓHg₁₋ₓTe, ledit substrat comportant pour chaque pixel :
- une région dopée N (120 ; 420), dédiée à l'absorption de photons incidents ;
- une région dopée P (130 ; 430 ; 530 ; 730 ; 930), formant une jonction PN avec la région dopée N et affleurant une face (111) supérieure du substrat ;
- un plot de contact électrique (170 ; 270A ; 270B ; 270C ; 470 ; 970A ; 970B), en métal, en contact physique direct avec la région dopée P ; et
- un caisson concentré (150), localisé uniquement dans la région dopée P et présentant une concentration moyenne en cadmium supérieure à la concentration moyenne en cadmium dans la région dopée N ;
**caractérisé en ce que** dans chaque pixel :
- le caisson concentré (150) présente un gradient de concentration en cadmium, définissant dans ce dernier au moins une zone de gap intermédiaire (151; 251A ; 251B ; 251C) et au moins une zone fort gap (152 ; 252A ; 252B ; 252C) ;
- la zone de gap intermédiaire (151; 251A; 251B ; 251C) présente une concentration moyenne en cadmium strictement inférieure à la concentration moyenne en cadmium dans la zone fort gap (152 ; 252A ; 252B ; 252C) ; et
- chaque zone de gap intermédiaire (151; 251A; 251B ; 251C) est en contact physique direct avec le plot de contact électrique (170 ; 270A ; 270B ; 270C ; 470 ; 970A ; 970B).

2. Dispositif de photo-détection (100 ; 300 ; 900A ; 900B) selon la revendication 1, **caractérisé en ce qu'**il comporte en outre un revêtement structuré (180 ; 280A ; 280B ; 280C ; 480 ; 680 ; 780 ; 880 ; 980A ; 980B) recouvrant la face supérieure du substrat, et dans lequel :
- le revêtement structuré comporte une couche riche en cadmium (180 ; 280A ; 280B ; 280C ; 480 ; 680₂ ; 780 ; 880 ; 980A ; 980B), constituée d'un alliage comprenant du cadmium et en contact physique direct avec le substrat semiconducteur ;
- le revêtement structuré comporte au moins une ouverture traversante (181 ; 481 ; 581) ; et
- dans chaque pixel, chaque zone de gap intermédiaire (151; 251A ; 251B ; 251C) du caisson concentré est surmontée par une ouverture traversante respective (181 ; 481 ; 581) du revêtement structuré.

3. Dispositif de photo-détection selon la revendication 2, **caractérisé en ce que** le revêtement structuré (680) comporte plusieurs couches superposées, parmi lesquelles une couche d'étanchéité (680₂), distincte de la couche riche en cadmium (680₁) et apte à bloquer le passage d'éléments dopants vers l'intérieur du substrat semiconducteur.

4. Dispositif de photo-détection (300 ; 900A; 900B) selon la revendication 2 ou 3, **caractérisé en ce qu'**il comporte au moins deux pixels (30), et **en ce que** chaque pixel (30) comporte un même nombre d'ouverture(s) traversante(s) dans le revêtement structuré, répartie(s) de la même façon sur le pixel et présentant les mêmes dimensions d'un pixel à l'autre.

5. Dispositif de photo-détection (100 ; 300 ; 900A ; 900B) selon l'une quelconque des revendications 1 à 4, **caractérisé en ce que** dans chaque pixel, chaque zone de gap intermédiaire (151; 251A; 251B; 251C) est entourée latéralement par une partie au moins de l'au moins une zone fort gap (152 ; 252A ; 252B ; 252C).

6. Dispositif de photo-détection (100 ; 300 ; 900A ; 900B) selon la revendication 5, **caractérisé en ce que** dans au moins un pixel, le caisson concentré comprend une unique zone de gap intermédiaire (151; 251A) et une unique zone fort gap (152 ; 252A), avec l'unique zone de gap intermédiaire entourée latéralement par l'unique zone fort gap.

7. Dispositif de photo-détection selon la revendication 5 ou 6, **caractérisé en ce que** dans au moins un pixel, le caisson concentré comprend une unique zone de gap intermédiaire (251B) et deux zones fort gap (252B), avec la zone de gap intermédiaire qui forme un volume ouvert au centre et avec les deux zones fort gap respectivement autour et au centre de la zone de gap intermédiaire.

8. Dispositif de photo-détection selon l'une quelconque des revendications 5 à 7, **caractérisé en ce que** dans au moins un pixel, le caisson concentré comprend une pluralité de zones de gap intermédiaire (251C), et une zone fort gap (252C) qui s'étend autour et entre les zones de gap intermédiaire.

9. Dispositif de photo-détection (100 ; 300 ; 900A ; 900B) selon l'une quelconque des revendications 1 à 8, **caractérisé en ce que** dans chaque pixel, la valeur minimale (xₘᵢₙ) de concentration en cadmium dans le caisson concentré est strictement supérieure à la valeur minimale de concentration en cadmium dans la région dopée N (120 ; 420).

10. Dispositif de photo-détection (300; 900A; 900B) selon l'une quelconque des revendications 1 à 9, **caractérisé en ce qu'**il comporte une pluralité de pixels (30) qui présentent tous une même longueur d'onde de coupure.

11. Dispositif de photo-détection (900A ; 900B) selon l'une quelconque des revendications 1 à 10, **caractérisé en ce que** le substrat semiconducteur présente une topologie mésa, avec, dans chaque pixel, un plot mésa (901) respectif recevant la région dopée P (930).

12. Procédé de fabrication d'un dispositif de photo-détection selon l'une quelconque des revendications 1 à 11, **caractérisé en ce qu'**il comprend les étapes suivantes :
a) réalisation, sur le substrat semiconducteur (410 ; 510 ; 810), d'un revêtement structuré (480 ; 680 ; 780 ; 880) comportant au moins une ouverture traversante (481 ; 581), avec ledit revêtement structuré qui comporte une couche riche en cadmium, constituée d'un alliage comprenant du cadmium et en contact physique direct avec le substrat semiconducteur ;
b) recuit de l'ensemble comportant le substrat semiconducteur et le revêtement structuré ;
le procédé comprenant en outre la réalisation, dans chaque pixel, d'une jonction PN qui sépare la région dopée N (420) et la région dopée P (430 ; 530 ; 730), avec la région dopée P située au regard de l'une au moins parmi l'au moins une ouverture traversante du revêtement structuré (480 ; 680 ; 780 ; 880), et le recuit réalisant une inter-diffusion sélective du cadmium depuis le revêtement structuré vers la région dopée P de chaque pixel.

13. Procédé selon la revendication 12, **caractérisé en ce que** dans chaque pixel, la réalisation de la jonction PN comporte une étape d'injection d'éléments dopants dans le substrat semiconducteur, cette étape étant mise en oeuvre après l'étape a) et les éléments dopants étant injectés à travers l'au moins une ouverture traversante (581) du revêtement structuré.

14. Procédé selon la revendication 13, **caractérisé en ce que** le revêtement structuré (680) comporte plusieurs couches superposées, parmi lesquelles une couche d'étanchéité (680₂), distincte de la couche riche en cadmium (680₁) et apte à bloquer le passage d'éléments dopants vers l'intérieur du substrat semiconducteur.

15. Procédé selon l'une quelconque des revendications 12 à 14, **caractérisé en ce qu'**il comporte en outre, pour chaque pixel, une étape de réalisation du plot de contact électrique (470) mise en oeuvre après l'épreuve b), avec le plot de contact électrique qui s'étend dans chaque ouverture traversante du revêtement structuré dans ledit pixel.

## Patentansprüche

1. Fotodetektionsvorrichtung (100; 300; 900A; 900B) mit mindestens einem Pixel, das ein Halbleitersubstrat (110; 310; 410; 510; 810) aus CdₓHg₁₋ₓTe umfasst, wobei das Substrat für jedes Pixel Folgendes umfasst:
- einen N-dotierten Bereich (120; 420), der für die Absorption einfallender Photonen vorgesehen ist;
- einen P-dotierten Bereich (130; 430; 530; 730; 930), der einen PN-Übergang mit dem N-dotierten Bereich bildet und bündig mit einer Oberseite (111) des Substrats abschließt;
- eine elektrische Kontaktfläche (170; 270A; 270B; 270C; 470; 970A; 970B) aus Metall, die in direktem physischen Kontakt mit dem P-dotierten Bereich steht; und
- eine konzentrierte Wanne (150), die sich nur im P-dotierten Bereich befindet und eine durchschnittliche Cadmiumkonzentration aufweist, die größer ist als die durchschnittliche Cadmiumkonzentration im N-dotierten Bereich;
**dadurch gekennzeichnet, dass** in jedem Pixel:
- die konzentrierte Wanne (150) einen Cadmiumkonzentrationsgradienten aufweist, der in letzterer mindestens eine mittlere Lückenzone (151; 251A; 251B; 251C) und mindestens eine große Lückenzone (152; 252A; 252B; 252C) definiert;
- die mittlere Lückenzone (151; 251A; 251B; 251C) eine durchschnittliche Cadmiumkonzentration aufweist, die deutlich unter der durchschnittlichen Cadmiumkonzentration in der hohen Lückenzone (152; 252A; 252B; 252C) liegt; und
- jede mittlere Lückenzone (151; 251A; 251B; 251C) in direktem physischen Kontakt mit der elektrischen Kontaktfläche (170; 270A; 270B; 270C; 470; 970A; 970B) steht.

2. Fotodetektionsvorrichtung (100; 300; 900A; 900B) nach Anspruch 1, **dadurch gekennzeichnet, dass** sie ferner eine strukturierte Beschichtung (180; 280A; 280B; 280C; 480; 680; 780; 880; 980A; 980B) umfasst, die die Oberseite des Substrats bedeckt, und wobei:
- die strukturierte Beschichtung eine cadmiumreiche Schicht (180; 280A; 280B; 280C; 480; 680₂; 780; 880; 980A; 980B) umfasst, die aus einer cadmiumhaltigen Legierung besteht und in direktem physikalischen Kontakt mit dem Halbleitersubstrat steht;
- die strukturierte Beschichtung mindestens eine Durchgangsöffnung (181; 481; 581) umfasst; und
- in jedem Pixel jede mittlere Lückenzone (151; 251A; 251B; 251C) der konzentrierten Wanne von einer jeweiligen Durchgangsöffnung (181; 481; 581) der strukturierten Beschichtung überragt wird.

3. Fotodetektionsvorrichtung nach Anspruch 2, **dadurch gekennzeichnet, dass** die strukturierte Beschichtung (680) mehrere übereinanderliegende Schichten umfasst, darunter eine Versiegelungsschicht (680₂), die von der cadmiumreichen Schicht (680₁) getrennt und dazu ausgelegt ist, den Durchgang von Dotierungselementen in Richtung des Inneren des Halbleitersubstrats zu blockieren.

4. Fotodetektionsvorrichtung (300; 900A; 900B) nach Anspruch 2 oder 3, **dadurch gekennzeichnet, dass** sie mindestens zwei Pixel (30) umfasst und dass jedes Pixel (30) die gleiche Anzahl von Durchgangsöffnung(en) in der strukturierten Beschichtung umfasst, die in gleicher Weise auf dem Pixel verteilt ist/sind und von einem Pixel zum anderen die gleichen Abmessungen aufweisen.

5. Fotodetektionsvorrichtung (100; 300; 900A; 900B) nach einem der Ansprüche 1 bis 4, **dadurch gekennzeichnet, dass** in jedem Pixel jede mittlere Lückenzone (151; 251A; 251B; 251C) seitlich von mindestens einem Teil der mindestens einen hohen Lückenzone (152; 252A; 252B; 252C) umgeben ist.

6. Fotodetektionsvorrichtung (100; 300; 900A; 900B) nach Anspruch 5, **dadurch gekennzeichnet, dass** die konzentrierte Wanne in mindestens einem Pixel eine einzelne mittlere Lückenzone (151; 251A) und eine einzelne große Lückenzone (152; 252A) umfasst, wobei die einzelne mittlere Lückenzone seitlich von der einzelnen hohen Lückenzone umgeben ist.

7. Fotodetektionsvorrichtung nach Anspruch 5 oder 6, **dadurch gekennzeichnet, dass** die konzentrierte Wanne in mindestens einem Pixel eine einzelne mittlere Lückenzone (251B) und zwei große Lückenzonen (252B) umfasst, wobei die mittlere Lückenzone in der Mitte ein offenes Volumen bildet und die beiden großen Lückenzonen jeweils um die mittlere Lückenzone herum und in deren Mitte liegen.

8. Fotodetektionsvorrichtung nach einem der Ansprüche 5 bis 7, **dadurch gekennzeichnet, dass** die konzentrierte Wanne in mindestens einem Pixel eine Vielzahl von mittleren Lückenzonen (251C) und eine große Lückenzone (252C) umfasst, die sich um die mittleren Lückenzonen und zwischen diesen erstreckt.

9. Fotodetektionsvorrichtung (100; 300; 900A; 900B) nach einem der Ansprüche 1 bis 8, **dadurch gekennzeichnet, dass** in jedem Pixel der Mindestwert (Xₘᵢₙ) der Cadmiumkonzentration in der konzentrierten Wanne deutlich über dem Mindestwert der Cadmiumkonzentration im N-dotierten Bereich (120; 420) liegt.

10. Fotodetektionsvorrichtung (300; 900A; 900B) nach einem der Ansprüche 1 bis 9, **dadurch gekennzeichnet, dass** sie eine Vielzahl von Pixeln (30) umfasst, die alle die gleiche Grenzwellenlänge aufweisen.

11. Fotodetektionsvorrichtung (900A; 900B) nach einem der Ansprüche 1 bis 10, **dadurch gekennzeichnet, dass** das Halbleitersubstrat eine Mesa-Topologie aufweist, wobei in jedem Pixel eine entsprechende Mesa-Fläche (901) den P-dotierten Bereich (930) aufnimmt.

12. Verfahren zum Herstellen einer Fotodetektionsvorrichtung nach einem der Ansprüche 1 bis 11, **dadurch gekennzeichnet, dass** es die folgenden Schritte umfasst:
a) Erzeugen einer strukturierten Beschichtung (480; 680; 780; 880), die mindestens eine Durchgangsöffnung (481; 581) umfasst, auf dem Halbleitersubstrat (410; 510; 810), wobei die strukturierte Beschichtung eine cadmiumreiche Schichtdicke umfasst, die aus einer Cadmiumlegierung besteht und in direktem physischen Kontakt mit dem Halbleitersubstrat steht;
b) Tempern des Ganzen, einschließlich des Halbleitersubstrats und der strukturierten Beschichtung;
wobei das Verfahren ferner das Erzeugen eines PN-Übergangs in jedem Pixel, der den N-dotierten Bereich (420) und den P-dotierten Bereich (430; 530; 730) trennt, wobei der P-dotierte Bereich in Bezug auf mindestens eine der mindestens einen Durchgangsöffnung der strukturierten Beschichtung (480; 680; 780; 880) angeordnet ist, und das Tempern umfasst, das eine selektive Interdiffusion von Cadmium aus der strukturierten Beschichtung in den P-dotierten Bereich jedes Pixels ausführt.

13. Verfahren nach Anspruch 12, **dadurch gekennzeichnet, dass** das Erzeugen des PN-Übergangs in jedem Pixel einen Schritt des Injizierens von Dotierungselementen im Halbleitersubstrat umfasst, wobei dieser Schritt nach Schritt a) durchgeführt wird und die Dotierungselemente durch die mindestens eine Durchgangsöffnung (581) der strukturierten Beschichtung injiziert werden.

14. Verfahren nach Anspruch 13, **dadurch gekennzeichnet, dass** die strukturierte Beschichtung (680) mehrere übereinanderliegende Schichten umfasst, darunter eine Versiegelungsschicht (680₂), die von der cadmiumreichen Schicht (680₁) getrennt und dazu ausgelegt ist, den Durchgang von Dotierungselementen in Richtung des Inneren des Halbleitersubstrats zu blockieren.

15. Verfahren nach einem der Ansprüche 12 bis 14, **dadurch gekennzeichnet, dass** es ferner für jedes Pixel einen Schritt des Erzeugens der elektrischen Kontaktfläche (470) umfasst, der nach Schritt b) durchgeführt wird, wobei sich die elektrische Kontaktfläche in jeder Durchgangsöffnung der strukturierten Beschichtung in dem Pixel erstreckt.

## Claims

1. Photo-detection device (100; 300; 900A; 900B) having at least one pixel, including a semiconductor substrate (110; 310; 410; 510; 810) made of CdₓHg₁₋ₓTe, said substrate including for each pixel:
- an N-doped region (120; 420), dedicated to the absorption of incident photons;
- a P-doped region (130; 430; 530; 730; 930), forming a PN junction with the N-doped region and flush with a top face (111) of the substrate;
- an electrical contact block (170; 270A; 270B; 270C; 470; 970A; 970B), made of metal, in direct physical contact with the P-doped region; and
- a concentrated casing (150), only located in the P-doped region and having an average cadmium concentration greater than the average cadmium concentration in the N-doped region;
**characterised in that** in each pixel:
- the concentrated casing (150) has a cadmium concentration gradient, defining therein at least one intermediate gap zone (151; 251A; 251B; 251C) and at least one high gap zone (152; 252A; 252B; 252C);
- the intermediate gap zone (151; 251A; 251B; 251C) has an average cadmium concentration strictly less than the average cadmium concentration in the high gap zone (152; 252A; 252B; 252C); and
- each intermediate gap zone (151; 251A; 251B; 251C) is in direct physical contact with the electrical contact block (170; 270A; 270B; 270C; 470; 970A; 970B).

2. Photo-detection device (100; 300; 900A; 900B) according to claim 1, **characterised in that** it further includes a structured coating (180; 280A; 280B; 280C; 480; 680; 780; 880; 980A; 980B) covering the top face of the substrate, and wherein:
- the structured coating includes a cadmium-rich layer (180; 280A; 280B; 280C; 480; 680₂; 780; 880; 980A; 980B), consisting of an alloy comprising cadmium and in direct physical contact with the semiconductor substrate;
- the structured coating includes at least one through opening (181; 481; 581); and
- in each pixel, each intermediate gap zone (151; 251A; 251B; 251C) of the concentrated casing is topped with a respective through opening (181; 481; 581) of the structured coating.

3. Photo-detection device according to claim 2, **characterised in that** the structured coating (680) includes several stacked layers, including a sealing layer (680₂), separate from the cadmium-rich layer (680₁) and capable of blocking the passage of doping elements inside the semiconductor substrate.

4. Photo-detection device (300; 900A; 900B) according to claim 2 or 3, **characterised in that** it includes at least two pixels (30), and **in that** each pixel (30) includes the same number of through opening(s) in the structured coating, distributed in the same way on the pixel and having the same dimensions from one pixel to another.

5. Photo-detection device (100; 300; 900A; 900B) according to any one of claims 1 to 4, **characterised in that** in each pixel, each intermediate gap zone (151; 251A; 251B; 251C) is surrounded laterally by at least a part of the at least one high gap zone (152; 252A; 252B; 252C).

6. Photo-detection device (100; 300; 900A; 900B) according to claim 5, **characterised in that** in at least one pixel, the concentrated casing comprises a single intermediate gap zone (151; 251A) and a single high gap zone (152; 252A), with the single intermediate gap zone surrounded laterally by the single high gap zone.

7. Photo-detection device according to claim 5 or 6, **characterised in that** in at least one pixel, the concentrated casing comprises a single intermediate gap zone (251B) and two high gap zones (252B), with the intermediate gap zone which forms an open volume at the centre and with the two high gap zones respectively around and at the centre of the intermediate gap zone.

8. Photo-detection device according to any one of claims 5 to 7, **characterised in that** in at least one pixel, the concentrated casing comprises a plurality of intermediate gap zones (251C), and a high gap zone (252C) which extends around and between the intermediate gap zones.

9. Photo-detection device (100; 300; 900A; 900B) according to any one of claims 1 to 8, **characterised in that** in each pixel, the minimum cadmium concentration value (xₘᵢₙ) in the concentrated casing is strictly greater than the minimum cadmium concentration value in the N-doped region (120; 420).

10. Photo-detection device (300; 900A; 900B) according to any one of claims 1 to 9, **characterised in that** it includes a plurality of pixels (30) which all have the same cut-off wavelength.

11. Photo-detection device (900A; 900B) according to any one of claims 1 to 10, **characterised in that** the semiconductor substrate has a mesa topology, with, in each pixel, a respective mesa block (901) receiving the P-doped region (930).

12. Method for manufacturing a photo-detection device according to any one of claims 1 to 11, **characterised in that** it comprises the following steps:
a) producing, on the semiconductor substrate (410; 510; 810), a structured coating (480; 680; 780; 880) including at least one through opening (481; 581), with said structured coating which includes a cadmium-rich layer, consisting of an alloy comprising cadmium and in direct physical contact with the semiconductor substrate;
b) annealing the whole including the semiconductor substrate and the structured coating;
the method further comprising producing, in each pixel, a PN junction which separates the N-doped region (420) and the P-doped region (430; 530; 730), with the P-doped region located in relation to at least one from the at least one through opening of the structured coating (480; 680; 780; 880), and the annealing carrying out a selective inter-diffusion of the cadmium from the structured coating to the P-doped region of each pixel.

13. Method according to claim 12, **characterised in that** in each pixel, producing the PN junction advantageously includes a step of injecting doping elements into the semiconductor substrate, this step being carried out after step a) and the doping elements being injected through at least one through opening (581) of the structured coating.

14. Method according to claim 13, **characterised in that** the structured coating (680) includes several stacked layers, including a sealing layer (680₂), separate from the cadmium-rich layer (680₁) and capable of blocking the passage of doping elements inside the semiconductor substrate.

15. Method according to any one of claims 12 to 14, **characterised in that** it further includes, for each pixel, a step of producing the electrical contact block (470) carried out after step b), with the electrical contact block which extends into each through opening of the structured coating in said pixel.
